# EUROPEAN PATENT SPECIFICATION

(11) **EP 2 487 116 B1**
(45) Date of publication and mention of the grant of the patent: **02.03.2016**
(21) Application number: 10821786.0
(22) Date of filing: 06.07.2010
(51) Int. Cl.: B65D 85/60, B65D 5/66

(54) **PACKAGING CONTAINER**
VERPACKUNGSBEHÄLTER
RÉCIPIENT D'EMBALLAGE

(30) Priority: 08.10.2009 JP 2009234241
(43) Date of publication of application: 15.08.2012
(73) Proprietor: Lotte Co., Ltd., Tokyo 160-0023 (JP)
(72) Inventor: ONOGI, Atsushi, Saitama-shi Saitama 336-8601 (JP); OGAKI, Mitsuko, Saitama-shi Saitama 336-8601 (JP)
(74) Representative: Witte, Weller & Partner Patentanwälte mbB
(86) International application number: PCT/JP2010/061466
(87) International publication number: WO 2011/043115

(56) References cited:
- WO-A1-2004/108563
- GB-A- 1 425 164
- GB-A- 2 448 787
- JP-A- 60 240 639
- JP-A- 2004 323 069
- JP-A- 2006 199 369
- JP-A- 2007 537 935
- US-B1- 6 398 020

## Description

### TECHNICAL FIELD

The present invention relates to a packaging container for containing sheet-shaped food pieces such as of chewing gum or chocolate.

### BACKGROUND ART

Packaging containers for containing sheet-shaped food pieces such as of chewing gum or chocolate are known as disclosed in PLT 1, PLT 2 and PLT 3.

In the packaging containers disclosed in PLT 1 and PLT 2, sheet-shaped food pieces are compactly contained upright in overlapping relation in two rows which are arranged with a level difference so that a back row is located at a higher level than a front row. With the arrangement disclosed in PLT 1 and PLT 2, sheet-shaped food pieces in the back row are located at a higher level than sheet-shaped food pieces in the front row in the packaging container, so that the food pieces can be easily taken out. Further, the sheet-shaped food pieces are temporarily bonded to the inside of the packaging container. Therefore, when some of the sheet-shaped food pieces in the front row are taken out, the sheet-shaped food pieces in the back row are prevented from being displaced.

PLT 3 proposes a packaging container which compactly contains sheet-shaped food pieces and ensures that the sheet-shaped food pieces can be easily taken out for eating even if one hand is unavailable. In the packaging container of PLT 3, the sheet-shaped food pieces are individually wrapped with sheet wrappers, and are each unwrapped by cutting the wrapper along a perforation line provided between a removable portion and a fixing portion and removing the removable portion. Further, the fixing portions of the sheet wrappers are fixed to the packaging container.

### CITATION LIST

PLT 4 describes a reclosable container for photographs or the like. PLT 5 relates to a container with a cylindrical trunk part, wherein both ends of the trunk part are open. Lid pieces extending from the end edges of the trunk part can be used to close the openings of the container.

### PATENT LITERATURE

PLT 1: JP3955355B
PLT 2: JP3955356B
PLT 3: JP2009-173322A
PLT 4: US 6 398 020 B1
PLT 5: JP 2004/323069 A

### SUMMARY OF INVENTION

### TECHNICAL PROBLEM

When the lid of such a prior-art packaging container containing the sheet-shaped food pieces is closed after one of the sheet-shaped food pieces is taken out with a lid of the packaging container being open, an engagement tongue provided at a distal edge of the lid should be inserted into an engagement cut-away portion or an engagement hole provided in a container body to maintain the lid in a closed state. This inserting operation is bothersome.

It is therefore a principal object of the present invention to provide a packaging container which is capable of compactly containing sheet-shaped food pieces, and has a novel lid closure retention structure which ensures that, when a lid is opened for taking out a sheet-shaped food piece and then closed, a lid closure maintaining operation can be easily performed to easily maintain the lid in a closed state.

It is another object of the present invention to provide a packaging container improved so that sheet-shaped food pieces contained therein can be easily taken out.

### SOLUTION TO PROBLEM

The invention is defined in the claims. According to an inventive aspect, there is provided a packaging container for containing sheet-shaped food pieces such as of chewing gum or chocolate, the packaging container including: a container body having an opening defined in at least an upper portion of a front face thereof and a top face thereof for taking out the content; and a flap-like lid provided integrally with the container body for covering the opening of the container body and having a proximal portion integrally connected to the container body and a free distal edge; the flap-like lid having an incision provided in a portion thereof adjacent to the distal edge to define a chevron-shaped tongue tapered toward the proximal portion; the container body having a receiving incision provided in a lower portion of the front face thereof for engagement with the chevron-shaped tongue when the flap-like lid is closed; the packaging container further including a retention structure which permits the chevron-shaped tongue to be engaged with the receiving incision by pressing the chevron-shaped tongue rearward from a front side by a finger when the flap-like lid is closed.

Advantageously, the container body has a second receiving incision provided in the lower portion of the front face thereof for receiving the distal edge of the flap-like lid in the packaging container.

According to a further inventive aspect, the proximal portion of the lid is connected integrally to an upper edge of a rear wall of the container body, and the rear wall of the container body has incisions provided in opposite upper corner portions thereof as extending obliquely inward from outer sides in the packaging container, whereby the proximal portion of the lid can be opened rearward of the container body when the flap-like lid is opened.

### ADVANTAGEOUS EFFECTS OF INVENTION

According to the inventive aspect, the lid can be easily maintained in a closed state by slightly pressing the incision provided in the lid from the front side, for example, by a forefinger with the distal edge of the lid supported, for example, by a thumb when the lid of the packaging container is closed.

Therefore, the packaging container ensures that, when the lid is closed after one of the sheet-shaped food pieces is taken out of the packaging container, the lid can be easily maintained in the closed state.

Moreover, the packaging container permits an easy lid closing operation and easy handling.

According to the further inventive aspect, the packaging container ensures that the sheet-shaped food pieces contained in the packaging container can be easily taken out.

### BRIEF DESCRIPTION OF DRAWINGS

FIG. 1 illustrates a crease pattern of a packaging container 10 according to one embodiment that is not part of the present invention.
FIG. 2 is a perspective view illustrating the packaging container 10 fabricated from the crease pattern shown in FIG. 1.
FIGS. 3 are schematic side sectional views for explaining how to close a lid 20 of the packaging container 10.
FIG. 4 is a diagram showing engagement between a chevron-shaped tongue 21A defined by an incision 21 and a receiving incision 22 as seen from a front side.
FIG. 5 illustrates a crease pattern of a packaging container 30 according to the present invention.
FIG. 6 is a perspective view illustrating the packaging container 30 fabricated from the crease pattern shown in FIG. 5 with a distal edge 20A of a lid 20 received by a second receiving incision 31.
FIG. 7 illustrates a crease pattern of a packaging container 40 according to another embodiment of the present invention.
FIG. 8 is a perspective view illustrating the packaging container 40 fabricated from the crease pattern shown in FIG. 7 with sheet-shaped gum pieces G contained therein and with a lid 20 thereof widely open as seen from a rear side.

### DESCRIPTION OF EMBODIMENTS

With reference to the drawings, embodiments of the present invention will hereinafter be described in detail.

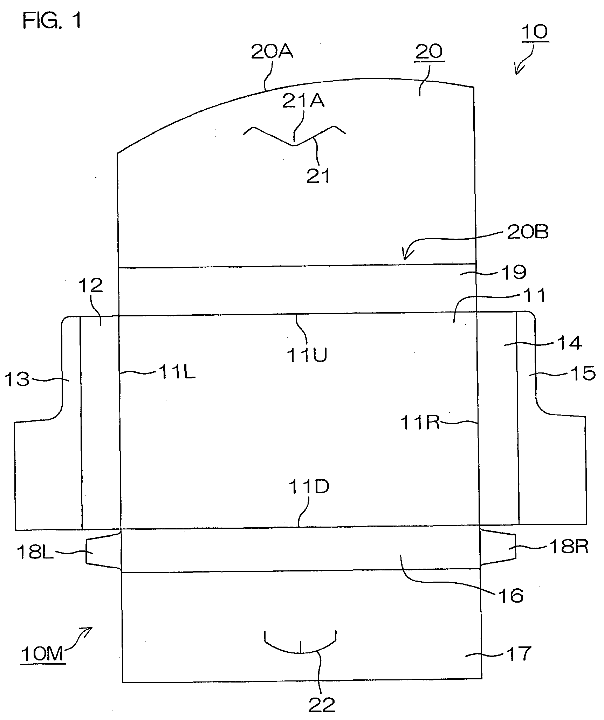

FIG. 1 illustrates a crease pattern of a packaging container 10 according to one embodiment that is not part of the present invention. The packaging container 10 is made of paper, and fabricated by folding and bonding the crease pattern of FIG. 1.

The crease pattern of the packaging container 10 includes a rear wall 11 having a horizontally elongated rectangular shape as seen from a front side, a left side wall 12 and a left front outline wall 13 which are continuous leftward from a left edge 11L of the rear wall 11, a right side wall 14 and a right front outline wall 15 which are continuous rightward from a right edge 11R of the rear wall 11, and a bottom wall 16 and a front face lower portion defining wall 17 which are continuous downward from a lower edge 11D of the rear wall 11. Small pieces 18L, 18R for filling gaps at left and right corners of the bottom of the fabricated container project laterally from opposite edges of the horizontally elongated rectangular bottom wall 16. The rear wall 11, the left and right side walls 12, 14, the left and right front outline walls 13, 15, the bottom wall 16 and the front face lower portion defining wall 17 are folded into the container body 10M of the packaging container 10.

Further, a horizontally elongated rectangular top wall 19 projects upward continuously from an upper edge 11U of the rear wall 11, and a flap-like lid 20 further extends upward from the top wall 19. The lid 20 has a proximal portion 20B connected to the top wall 19, and a convexly curved distal edge 20A (upper edge in FIG. 1).

The lid 20 has an incision 21 provided in a laterally middle portion thereof adjacent to the distal edge 20A (upper edge as seen vertically in FIG. 1) to define a chevron-shaped tongue 21A tapered toward the proximal portion 20B (having an inverted chevron shape or an inverted triangular shape in FIG. 1).

Further, the front face lower portion defining wall 17 has a receiving incision 22 curved convexly downward.

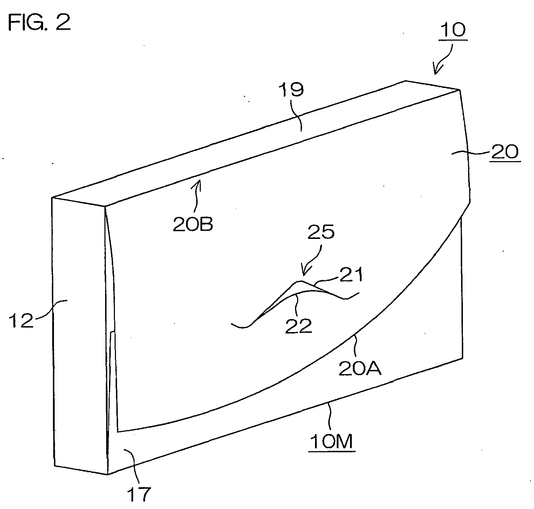

FIG. 2 is a perspective view illustrating the packaging container 10 fabricated from the crease pattern shown in FIG. 1. In FIG. 2, the same portions as those of the crease pattern described with reference to FIG. 1 are designated by the same reference numerals. As shown in FIG. 2, the fabricated packaging container 10 includes a retention structure 25 which causes the chevron-shaped tongue 21A defined by the incision 21 to engage the receiving incision 22 to maintain the closed lid 20 in the closed state.

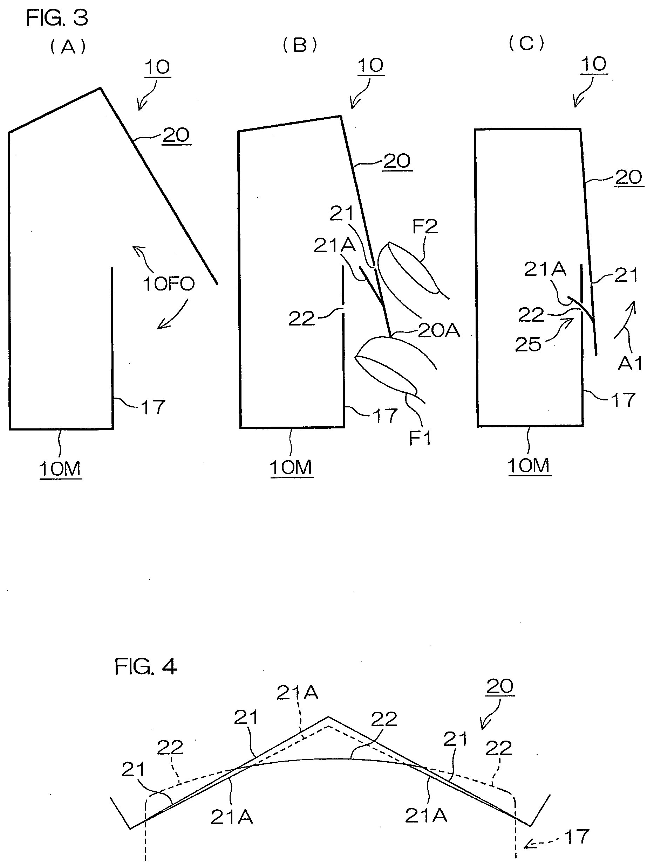

FIGS. 3 are schematic side sectional views for explaining how to close the lid 20 of the packaging container 10. As shown in FIG. 3(A), the lid 20 is turned obliquely downward toward a front opening 10FO of the container body 10M to close the front opening 10FO of the container body 10M. Then, as shown in FIG. 3(B), the incision 21 of the lid 20 is slightly pressed from the front side, for example, by a forefinger F2 with the distal edge 20A of the lid 20 supported, for example, by a thumb F1 in order to maintain the lid 20 in the closed state. Then, the chevron-shaped tongue 21A defined by the incision 21 projects inward. The lid 20 is pressed against the container body 10M, whereby the chevron-shaped tongue 21A is inserted into the receiving incision 22 provided in the front face lower portion defining wall 17 to maintain the lid 20 in the closed state as shown in FIG. 3(C). At this time, a small stress acts on the lid 20 in an opening direction as indicated by an arrow A1, so that the lid 20 is maintained in the closed state against the stress.

FIG. 4 is a diagram showing the engagement between the chevron-shaped tongue 21A defined by the incision 21 and the receiving incision 22 as seen from the front side. As shown, a tapered distal portion of the chevron-shaped tongue 21A defined by the incision 21 is inserted upward from a lower side into the receiving incision 22. Thus, the lid 20 is engaged with the front face lower portion defining wall 17 to be maintained in the closed state.

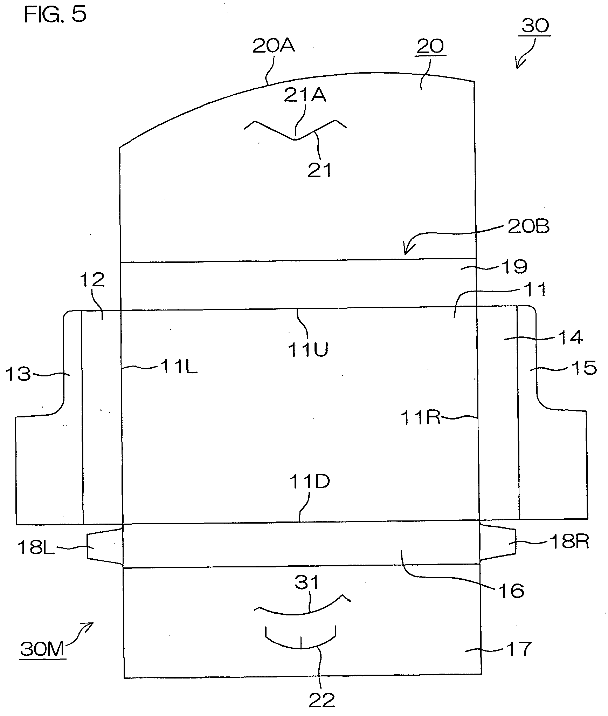

FIG. 5 illustrates a crease pattern of a packaging container 30 according to one embodiment of the present invention. In FIG. 5, portions equivalent to those shown in FIG. 1 are designated by the same reference numerals.

The packaging container 30 shown in FIG. 5 features that the front face lower portion defining wall 17 of the container body 30M has a second receiving incision 31 in addition to the receiving incision 22. The second receiving incision 31 is provided in a portion of the front face lower portion defining wall 17 adjacent to the bottom wall 16 (at a position higher than the receiving incision 22 in FIG. 5). The second receiving incision 31 receives the distal edge 20A of the lid 20 as will be described later.

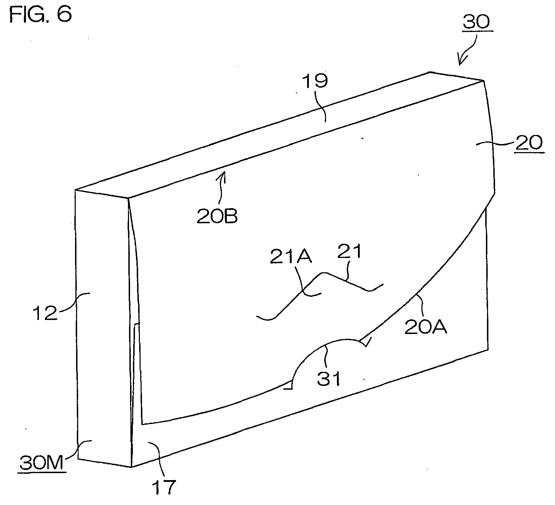

FIG. 6 is a perspective view illustrating the packaging container 30 fabricated from the crease pattern shown in FIG. 5 with the distal edge 20A of the lid 20 received by the second receiving incision 31. As shown in FIG. 6, the provision of the second receiving incision 31 in the front face lower portion defining wall 17 permits engagement between the distal edge 20A of the lid 20 and the second receiving incision 31 in order to maintain the lid 20 in the closed state when the lid 20 is closed.

As described with reference to FIGS. 3 and 4, the lid 20 may be maintained in the closed state by the engagement between the chevron-shaped tongue 21A defined by the incision 21 provided in the lid 20 and the receiving incision 22 (not shown in FIG. 6, see FIG. 5).

The provision of the two receiving incisions 22, 31, i.e., the receiving incision 22 and the second receiving incision 31, ensures that the packaging container 30 can be more easily kept closed with the lid 20, because a convenient one of these two receiving incisions 22, 31 can be used for maintaining the lid 20 in the closed state.

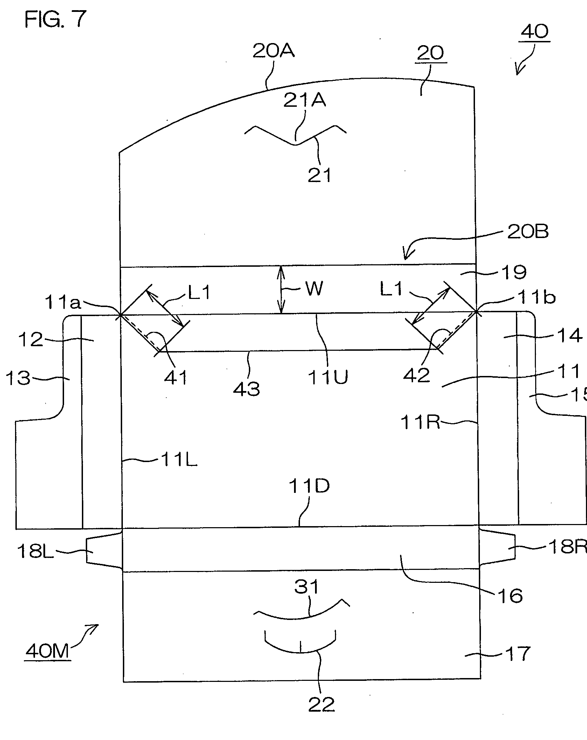

FIG. 7 illustrates a crease pattern of a packaging container 40 according to another embodiment of the present invention. In FIG. 7, portions equivalent to those shown in FIGS. 1 and 5 are designated by the same reference numerals.

The packaging container 40 shown in FIG. 7 features that the rear wall 11 has perforation lines 41, 42 which respectively extend from left and right upper corners 11a, 11b of the rear wall 11 toward a center portion of the rear wall 11. The length L1 of each of the perforation lines 41, 42 is, for example, substantially equal to the width W (vertical dimension in FIG. 7) of the top wall 19, i.e., L1≈W. A fold line 43 is provided which connects distal ends (lower ends in FIG. 7) of the perforation lines 41, 42.

The packaging container 40 has the same other construction as the packaging container 30 shown in FIG. 5.

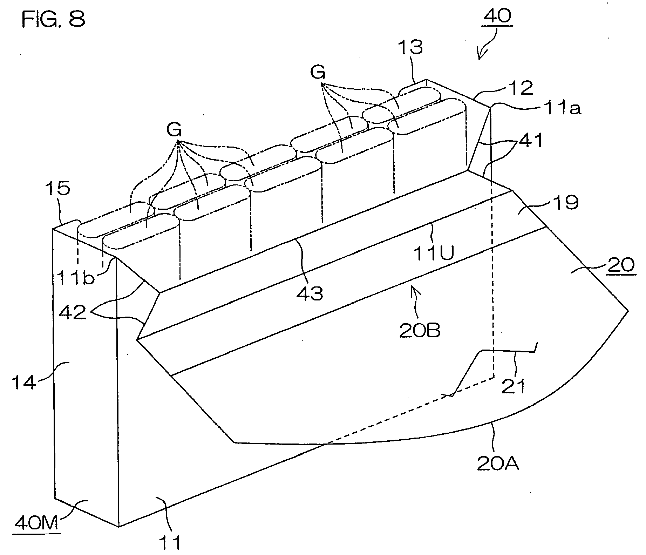

FIG. 8 is a perspective view illustrating the packaging container 40 fabricated from the crease pattern shown in FIG. 7 in a state such that individually wrapped sheet-shaped gum pieces G are contained as a commercial product in two front and back rows therein and the lid 20 is opened with the commercial product (sheet-shaped gum pieces G) contained therein. In FIG. 8, the packaging container 40 is seen in perspective from an upper right rear side.

In the packaging container 40, as described with reference to FIG. 7, the perforation lines 41, 42 extend from the left and right upper corners 11a, 11b of the rear wall 11. When the lid 20 is opened, therefore, the lid 20 and the top wall 19 are moved rearward with respect to the container body 40M to form an opening. When the lid 20 is further opened, the rear wall 11 is cut along the perforation lines 41, 42 and, as shown in FIG. 8, the lid 20 and the top wall 19 can be widely opened rearward of the container body 40M. At this time, an upper portion of the rear wall 11 is folded along the fold line 43, so that an upper portion of the container body 40M can be exposed to the front side as well as to the rear side.

Therefore, upper portions of the sheet-shaped gum pieces G contained in the container body 40M are exposed to the front side as well as to the rear side, so that the sheet-shaped gum pieces G contained in the two rows, i.e., in the front and back rows, can be easily taken out.

Thus, the packaging container 40 according to this embodiment is effective in that the contained sheet-shaped gum pieces G can be easily taken out from the rear side, because a wide opening can be provided by opening the upper portion of the rear wall 11 as well as the lid 20.

Specific examples of the sheet-shaped food pieces to be contained in each of the packaging containers 10, 30, 40 of the embodiments described above and the method of individually wrapping the sheet-shaped food pieces are described in Patent Application No. 2008-15908 (JP2009-173322A) previously filed by the applicant of the present invention.

Besides, various modifications may be made within the scope of the present invention described in the claims.

### REFERENCE SIGNS LIST

10, 30, 40: PACKAGING CONTAINER
10M, 30M, 40M: CONTAINER BODY
10FO: FRONT OPENING
11: REAR WALL
11L: LEFT EDGE
11R: RIGHT EDGE
11D: LOWER EDGE
11U: UPPER EDGE
11a: LEFT UPPER CORNER
11b: RIGHT UPPER CORNER
12: LEFT SIDE WALL
13: LEFT FRONT OUTLINE WALL
14: RIGHT SIDE WALL
15: RIGHT FRONT OUTLINE WALL
16: BOTTOM WALL
17: FRONT FACE LOWER PORTION DEFINING WALL
18L, 18R: SMALL PIECE
19: TOP WALL
20: LID
20A: DISTAL EDGE
20B: PROXIMAL PORTION
21: INCISION
21A: CHEVRON-SHAPED TONGUE
22: RECEIVING INCISION
25: RETENTION STRUCTURE
31: SECOND RECEIVING INCISION
41, 42: PERFORATION LINE
43: FOLD LINE
A1: ARROW
F1: THUMB
F2: FOREFINGER
G: SHEET-SHAPED GUM PIECE
L1: LENGTH
W: WIDTH

## Claims

1. A packaging container (10; 30; 40) for containing sheet-shaped food pieces (G) such as of chewing gum or chocolate, the packaging container comprising:
a container body (10M; 30M; 40M) having an opening (10FO) defined in at least an upper portion of a front face (17) thereof and a top face thereof for taking out the content; and
a flap-like lid (20) provided integrally with the container body (10M; 30M; 40M) for covering the opening (10FO) of the container body and having a proximal portion (20B) integrally connected to the container body and a free convexly curved distal edge (20A);
the flap-like lid (20) having an incision (21) provided in a portion thereof adjacent to the distal edge to define a chevron-shaped tongue (21A) tapered toward the proximal portion (20B);
the container body (10M; 30M; 40M) having a receiving incision (22) provided in a lower portion of the front face (17) thereof for engagement with the chevron-shaped tongue (21A) when the flap-like lid (20) is closed;
the packaging container (10M; 30M; 40M) further comprising a retention structure (25) which permits the chevron-shaped tongue (21A) to be engaged with the re-ceiving incision (22) by pressing the chevron-shaped tongue (21A) rearward from a front side by a finger when the flap-like lid (20) is closed;
**characterized in that**
the container body has a second receiving incision (31) provided in the lower portion of the front face (17) thereof for receiving the distal edge (20A) of the flap-like lid (20), wherein the first receiving incision (22) and the second receiving incision (31) are curved convexly towards the upper portion of the front face (17).

2. The packaging container according to claim 1,
wherein the proximal portion (20B) of the lid (20) is connected integrally to an upper edge (11U) of a rear wall (11) of the container body (40M), and the rear wall (11) of the container body (40M) has incisions (41, 42) provided in opposite upper corner portions thereof as extending obliquely inward from outer sides,
whereby the proximal portion (20B) of the lid (20) can be opened rearward of the container body (40M) when the flap-like lid (20) is opened.

## Patentansprüche

1. Verpackungsbehälter (10; 30; 40) zum Aufbewahren von plattenförmigen Nahrungsmittelstücken (G), wie von Kaugummi oder Schokolade, wobei der Verpackungsbehälter aufweist:
einen Behälterkörper (10M; 30M; 40M) mit einer Öffnung (10FO), der in wenigstens einem oberen Abschnitt einer Vorderseite (17) des Behälterkörpers und einer Oberseite des Behälterkörpers definiert ist, um den Inhalt herauszunehmen; und
eine laschenartige Abdeckung (20), die einstückig mit dem Behälterkörper (10M; 30M; 40M) vorgesehen ist, um die Öffnung (10FO) des Behälterkörpers abzudecken, und die einen proximalen Abschnitt (20B), der einstückig mit dem Behälterkörper verbunden ist, und eine konvex gekrümmte freie distale Kante (20A) aufweist;
wobei die laschenartige Abdeckung (20) einen Einschnitt (21) aufweist, der in einem Abschnitt der Abdeckung benachbart zu der distalen Kante vorgesehen ist, um eine zackenförmige Zunge (21A) zu defnieren, die sich zu dem proximalen Abschnitt (20B) hin verjüngt;
wobei der Behälterkörper (10M; 30M; 40M) einen Aufnahmeeinschnitt (22) aufweist, der in einem unteren Abschnitt der Vorderseite (17) des Behälterkörpers für ein Eingreifen mit der zackenförmigen Zunge (21 A) vorgesehen ist, wenn die laschenartige Abdeckung (20) geschlossen ist;
wobei der Verpackungsbehälter (10M; 30M; 40M) ferner eine Sicherungsstruktur (25) aufweist, die der zackenförmigen Zunge (21A) erlaubt, mit dem Aufnahmeeinschnitt (22) in Eingriff zu gelangen, und zwar durch nach hinten Drücken der zackenförmigen Zunge (21A) von einer Vorderseite mittels eines Fingers, wenn die laschenartige Abdeckung (20) geschlossen wird;
**dadurch gekennzeichnet, dass**
der Behälterkörper einen zweiten Aufnahmeeinschnitt (31) aufweist, der in dem unteren Abschnitt der Vorderseite (17) des Behälterkörpers vorgesehen ist, um die distale Kante (20A) der laschenartigen Abdeckung (20) aufzunehmen, wobei der erste Empfängerschnitt (22) und der zweite Empfängerschnitt (31) zu dem oberen Abschnitt der Vorderseite (17) hin konvex gekrümmt verlaufen.

2. Verpackungscontainer nach Anspruch 1,
wobei der proximale Abschnitt (20B) der Abdeckung (20) einstückig mit einer oberen Kante (1U) einer Rückwand (11) des Behälterkörpers (40M) verbunden ist, und die Rückwand (11) des Behälterkörpers (40M) Einschnitte (41, 42) aufweist, die in gegenüberliegenden oberen Eckabschnitten des Behälterkörpers von den Außenseiten schräg nach innen verlaufend vorgesehen sind, wobei der proximale Abschnitt (20B) der Abdeckung (20) hinter den Behälterkörper (40M) geöffnet werden kann, wenn die laschenartige Abdeckung (20) geöffnet ist.

## Revendications

1. Récipient (10 ; 30 ; 40) d'emballage destiné à contenir des morceaux (G) d'aliments en forme de feuille, par exemple de chewing-gum ou de chocolat, le récipient d'emballage comportant :
un corps (10M ; 30M ; 40M) de récipient comprenant une ouverture (10FO) définie dans au moins une partie supérieure d'une face avant (17) de celui-ci et d'une face supérieure de celui-ci pour sortir le contenu ; et
un couvercle (20) en volet réalisé d'un seul tenant avec le corps (10M ; 30M ; 40M) de récipient pour recouvrir l'ouverture (10FO) du corps de récipient et doté d'une partie proximale (20B) reliée de façon intégrée au corps de récipient et d'un bord distal (20A) libre incurvé de façon convexe ;
le couvercle (20) en volet présentant une incision (21) réalisée dans une partie de celui-ci adjacente au bord distal pour définir une languette (21 A) en forme de chevron rétrécie en direction de la partie proximale (20B) ;
le corps (10M ; 30M ; 40M) de récipient présentant une incision réceptrice (22) réalisée dans une partie inférieure de la face avant (17) de celui-ci en vue d'interagir avec la languette (21 A) en forme de chevron lorsque le couvercle (20) en volet est fermé ;
le récipient d'emballage (10M ; 30M ; 40M) comportant en outre une structure (25) de retenue qui permet à la languette (21A) en forme de chevron d'être mise en interaction avec l'incision réceptrice (22) en pressant la languette (21A) en forme de chevron vers l'arrière par rapport à un côté avant avec un doigt lorsque le couvercle (20) en volet est fermé ;
**caractérisé en ce que**
le corps de récipient présente une deuxième incision réceptrice (31) réalisée dans la partie inférieure de la face avant (17) de celui-ci pour recevoir le bord distal (20A) du couvercle (20) en volet, la première incision réceptrice (22) et la deuxième incision réceptrice (31) étant incurvées de façon convexe en direction de la partie supérieure de la face avant (17).

2. Récipient d'emballage selon la revendication 1,
La partie proximale (20B) du couvercle (20) étant reliée de façon intégrée à un bord supérieur (11 U) d'une paroi arrière (11) du corps (40M) de récipient, et la paroi arrière (11) du corps (40M) de récipient présentant des incisions (41, 42) réalisées dans des parties de coins supérieurs opposés de celle-ci de façon à s'étendre obliquement vers l'intérieur à partir des côtés extérieurs,
la partie proximale (20B) du couvercle (20) pouvant ainsi être ouverte vers l'arrière du corps (40M) de récipient lorsque le couvercle (20) en volet est ouvert.
